# EUROPEAN PATENT APPLICATION

(11) **EP 4 766 148 A2**
(43) Date of publication of application: **24.06.2026**
(21) Application number: 25222242.7
(22) Date of filing: 10.12.2025
(51) Int. Cl.: H10W 74/15, H10W 72/00, H10W 90/10, H10W 90/00, H10W 42/00

(54) **MODULE AND APPARATUS**

(30) Priority: 17.12.2024 JP 2024220781
(71) Applicant: Canon Kabushiki Kaisha, Tokyo, 146-8501 (JP)
(72) Inventor: MINEGISHI, Kunihiko, Tokyo, 146-8501 (JP)
(74) Representative: Canon Europe Limited

(57) **Abstract**

A width (Dc) of an intermediate portion (33), which is defined by a first semiconductor element (10) and a second semiconductor element (20), is smaller than a sum of a thickness (Ta) of a lower portion (31) and a thickness (Tb) of a lower portion (32), and a distance (Da) from at least part of a contour (10) of a projection of the first semiconductor element (10) onto the mounting surface (2) to at least part of an outer edge (311) of a board bonding surface, which is a bonding surface (300) of the adhesive (30) bonded to the wiring board (1), is smaller than the width (Dc).

## Description

### TECHNICAL FIELD

The technique according to the present disclosure relates to a module including a wiring board, a semiconductor element, and an adhesive.

### BACKGROUND

Japanese Patent Laid-Open No. 2007-134540 discloses a semiconductor device in which a plurality of semiconductor elements are face-down mounted on a circuit board via bumps, and in which the gap between the lower surfaces of the semiconductor elements and the upper surface of the circuit board is filled with an underfill resin.

In this technical field, the mechanical characteristics of modules have been an issue.

### SUMMARY

The present disclosure is directed to provide a module having excellent mechanical characteristics.

The present disclosure in its first aspect provides a module as specified in claim 1. Optional features are specified in claims 2 to 17.

The present disclosure in its second aspect provides an apparatus as specified in claim 18. Optional features of the second aspect may be provided by or derivable from claims 2 to 17.

Features of the present disclosure will become apparent from the following description of embodiments with reference to the attached drawings. The following description of embodiments is described by way of example.

### BRIEF DESCRIPTION OF THE DRAWINGS

Fig. 1A is a top view of a module according to a first embodiment of the present disclosure.
Fig. 1B is a cross-sectional view of the module taken along line IB-IB in Fig. 1A.
Fig. 2A is an enlarged view of a portion of a cross-sectional view of the module including an intermediate portion.
Fig. 2B is an enlarged view of a portion of a cross-sectional view of the module including an end portion.
Fig. 3A is a top view of a module according to a second embodiment.
Fig. 3B is a cross-sectional view of the module taken along line IIIB-IIIB illustrated in Fig. 3A.
Fig. 4A is a top view of a module according to a third embodiment.
Fig. 4B is a cross-sectional view of the module taken along line IVB-IVB illustrated in Fig. 4A.
Fig. 5A is a top view of a module according to a fourth embodiment.
Fig. 5B is a cross-sectional view of the module taken along line VB-VB illustrated in Fig. 5A.
Figs. 6A and 6B are cross-sectional views of a module according to a fifth embodiment, illustrating a manufacturing process thereof.
Fig. 6C is a cross-sectional view of a module according to a sixth embodiment.
Fig. 7A is a diagram illustrating a module according to a seventh embodiment.
Fig. 7B is a diagram illustrating a step of injecting an adhesive to the lower surfaces of the semiconductor elements.
Fig. 7C is a diagram illustrating a state after the adhesive is cured by heating.
Fig. 7D is a diagram illustrating a state in which the masking tapes have been removed after curing of the adhesive.
Fig. 8 is a diagram illustrating a camera system according to an eighth embodiment.
Fig. 9 is a diagram illustrating a module according to a reference mode, illustrating warpage caused when the adhesive expands.

### DESCRIPTION OF THE EMBODIMENTS

Embodiments will be described hereinbelow with reference to the drawings. It should be noted that the following embodiments are not intended to limit the invention as claimed. The various embodiments include multiple features, but not all of these features are essential, and the features may be combined arbitrarily or where there is a benefit. That is to say, each of the embodiments of the present disclosure can be implemented solely or as a combination of a plurality of the embodiments. Each feature or element of each embodiment of the present disclosure can be implemented as a combination of features of elements in a single embodiment. Each modification of one embodiment may be combined with one or more other modifications of the same embodiment. Each modification of one embodiment may be combined with one or more modification of the same embodiment or another embodiment wherein appropriate. In the following description and drawings, identical reference numerals are used for elements that are common across a plurality of drawings. Accordingly, the common structures are described with reference to multiple drawings, and repeated explanation of elements denoted by the same reference numerals is omitted as appropriate.

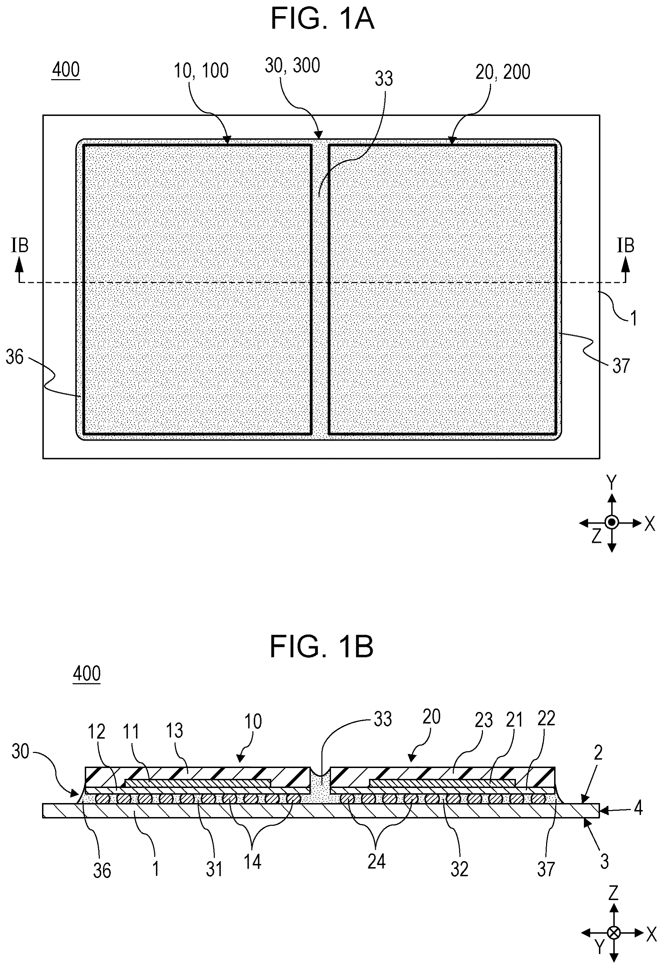

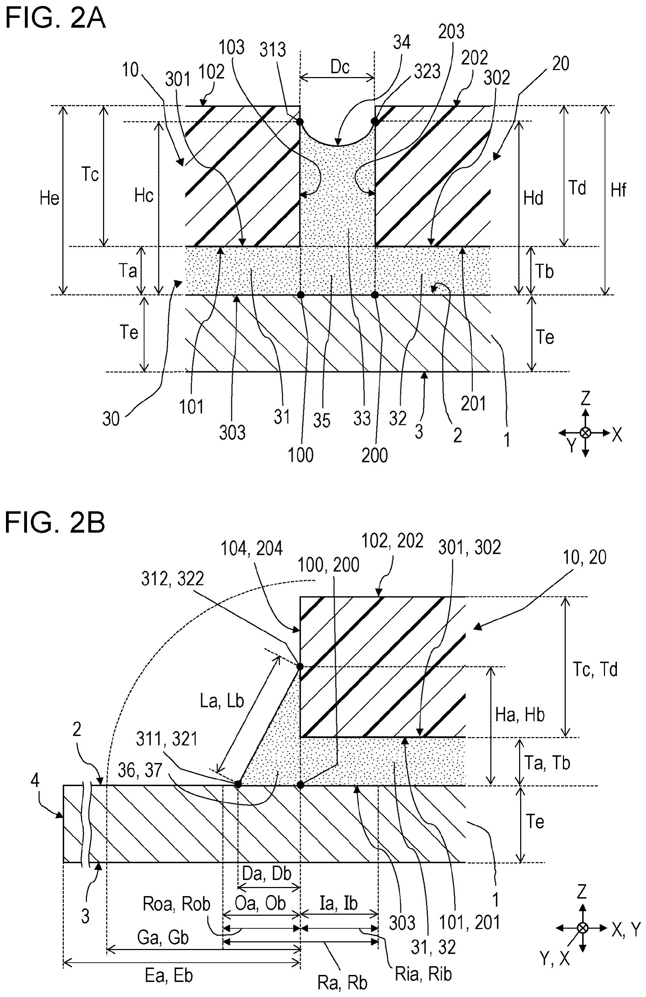

A first embodiment of the present disclosure will be described with reference to Figs. 1A and 1B and Figs. 2A and 2B. Figs. 1A and 1B illustrate the relevant part of a module according to the first embodiment. Fig. 1A is a top view of a module 400. Fig. 1B is a cross-sectional view of the module 400 taken along line IB-IB in Fig. 1A.

The module 400 includes a wiring board 1, a semiconductor element 10 (a first semiconductor element), a semiconductor element 20 (a second semiconductor element), and an adhesive 30.

The wiring board 1 has a mounting surface 2. The wiring board 1 further has an opposite surface 3 opposite to the mounting surface 2 and end faces 4 connecting the mounting surface 2 and the opposite surface 3. The opposite surface 3 may also be used as a mounting surface, described later.

The semiconductor element 10 is electrically connected to the wiring board 1 and overlaps with the wiring board 1 in the Z direction perpendicular to the mounting surface 2. The semiconductor element 20 is electrically connected to the wiring board 1 and overlaps with the wiring board 1 in the Z direction perpendicular to the mounting surface 2. The semiconductor element 10 and the semiconductor element 20 are arranged side by side in the X direction along the mounting surface 2.

In Fig. 1A, the contour 100 of a projection of the semiconductor element 10 onto a plane including the mounting surface 2 in the Z direction is indicated by a bold line, and the contour 200 of a projection of the semiconductor element 20 onto a plane including the mounting surface 2 in the Z direction is indicated by a bold line.

The electrical connection between the semiconductor element 10 and the wiring board 1 is made through a plurality of conductive members 14. The plurality of conductive members 14 may be conductive balls or conductive bumps disposed between the semiconductor element 10 and the wiring board 1. The plurality of conductive members 14 may be metal bumps, solder balls, conductive resin, or a combination thereof. The structure is not limited to having a plurality of conductive members 14 disposed between the semiconductor element 10 and the wiring board 1; alternatively, conductive wires may be used as the conductive members 14 to form an electrical connection between the semiconductor element 10 and the wiring board 1 outside the region between them. In this case, the plurality of conductive members 14, which are conductive wires, are wire-bonded to the semiconductor element 10 and the wiring board 1.

The electrical connection between the semiconductor element 20 and the wiring board 1 is made through a plurality of conductive members 24. The plurality of conductive members 24 may be conductive balls or conductive bumps disposed between the semiconductor element 20 and the wiring board 1. The plurality of conductive members 24 may be metal bumps, solder balls, conductive resin, or a combination thereof. The structure is not limited to having a plurality of conductive members 24 disposed between the semiconductor element 20 and the wiring board 1; alternatively, conductive wires may be used as the conductive members 24 to form an electrical connection between the semiconductor element 20 and the wiring board 1 outside the region between them. In this case, the plurality of conductive members 24, which are conductive wires, are wire-bonded to the semiconductor element 20 and the wiring board 1.

The adhesive 30 bonds, on the mounting surface 2, to the wiring board 1, the semiconductor element 10, and the semiconductor element 20. The adhesive 30 is formed by solidifying a liquid adhesive through drying and/or curing the adhesive through polymerization. The adhesive 30 is typically made of resin and functions as a reinforcing material, a sealing material, or an underfill material.

Fig. 1A illustrates a contour 300, which is the contour of a projection of the adhesive 30 onto a plane including the mounting surface 2 in the Z direction. The region enclosed by the contour 300 is hatched; however, the adhesive 30 is not necessarily present throughout the entire region enclosed by the contour 300. Typically, the adhesive 30 is absent in portions within the contour 300 where the conductive members 14 and 24 are present.

As illustrated in Fig. 1B, the adhesive 30 has a lower portion 31, a lower portion 32, and an intermediate portion 33. The lower portion 31 is located between the wiring board 1 and the semiconductor element 10 in the Z direction. The lower portion 32 is located between the wiring board 1 and the semiconductor element 20 in the Z direction. The intermediate portion 33 is located between the semiconductor element 10 and the semiconductor element 20 in the X direction. The adhesive 30 further has an end portion 36 that forms part of the contour 300 in the vicinity of the semiconductor element 10 and an end portion 37 that forms part of the contour 300 in the vicinity of the semiconductor element 20. The intermediate portion 33 and the end portions 36 and 37 are also illustrated in Fig. 1A.

The end portions 36 and 37 are exposed to a void space. The void space is typically a gaseous space such as air, but may alternatively be a vacuum or a space filled with liquid. By exposing the end portions 36 and 37 to a void space, the mechanical characteristics of the module 400 can be controlled by the shapes of the end portions 36 and 37.

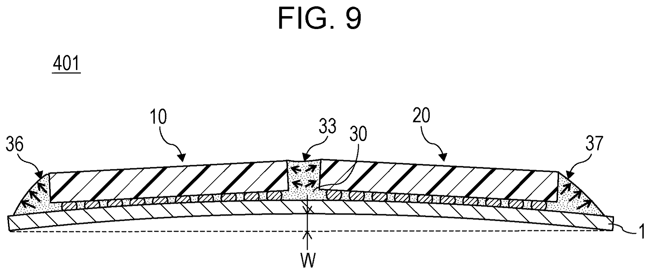

The issue to be solved by this embodiment will be described with reference to Fig. 9. In a module 401 according to the reference mode illustrated in Fig. 9, the semiconductor elements 10 and 20 are mounted over the wiring board 1, and the adhesive 30 is provided. When a liquid adhesive used to form the adhesive 30 solidifies and/or cures, shrinkage may occur. When the adhesive 30 undergoes a temperature change during manufacture or use of the module 401, expansion or shrinkage may occur in accordance with the coefficient of thermal expansion of the adhesive 30. In particular, when the intermediate portion 33 and the end portions 36 and 37 of the adhesive 30 are large in volume, such expansion or shrinkage of the adhesive 30 may cause deformation such as warpage (W) of the wiring board 1. Fig. 9 illustrates warpage (W) caused when the adhesive 30 expands, whereas warpage in the opposite direction may occur when the adhesive 30 shrinks. Such deformation may have an undesirable effect during manufacture or use. Specifically, such deformation may cause a decrease in the yield, reliability, performance, and service life of the module 401. For example, such effects may include a reduction in the reliability of the connection between the wiring board 1 and the semiconductor elements 10 and 20 or damage to the semiconductor elements 10 and 20. In addition, such deformation may also affect the connection state between a member (not shown) in the module 401 and the wiring board 1 or the semiconductor elements 10 and 20.

Accordingly, this embodiment provides a module having excellent mechanical characteristics by reducing the volumes of the intermediate portion 33 and the end portions 36 and 37 to suppress deformation of the wiring board 1. Preferable items for reducing the volumes of the intermediate portion 33 and the end portions 36 and 37 will be described hereinbelow.

Fig. 2A is an enlarged view of a portion of a cross-sectional view of the module 400 including the intermediate portion 33. Fig. 2B is an enlarged view of a portion of a cross-sectional view of the module 400 including the end portion 36 or 37. For simplification of the explanation, with reference to Fig. 2B, elements associated with the semiconductor element 10 and elements associated with the semiconductor element 20 will be described as being similar. In Fig. 2B, the elements associated with the semiconductor element 10 (for example, the end portion 36 that forms part of the contour 300 in the vicinity of the semiconductor element 10) are denoted by reference signs without brackets. The elements associated with the semiconductor element 20 (for example, the end portion 37 that forms part of the contour 300 in the vicinity of the semiconductor element 20) are denoted by reference signs with brackets.

The semiconductor element 10 has a lower surface 101 that faces the wiring board 1, an upper surface 102 that is opposite to the lower surface 101, and a facing side surface 103 that faces the semiconductor element 20.

The semiconductor element 20 has a lower surface 201 that faces the wiring board 1, an upper surface 202 that is opposite to the lower surface 201, and a facing side surface 203 that faces the semiconductor element 10.

The adhesive 30 has a bonding surface 301 that bonds to the semiconductor element 10. The bonding surface 301 has a bonding region of the adhesive 30 that bonds to the lower surface 101 of the semiconductor element 10 and a bonding region of the adhesive 30 that bonds to the facing side surface 103 of the semiconductor element 10. An end of the bonding surface 301 in the vicinity of the facing side surface 103 is an inner end 313. The inner end 313 may be located on the facing side surface 103, as in the example of Fig. 2A, but may alternatively be located on the upper surface 102.

The adhesive 30 has a bonding surface 302 that bonds to the semiconductor element 20. The bonding surface 302 has a bonding region of the adhesive 30 that bonds to the lower surface 201 of the semiconductor element 20 and a bonding region of the adhesive 30 that bonds to the facing side surface 203 of the semiconductor element 20. An end of the bonding surface 302 in the vicinity of the facing side surface 203 is an inner end 323. The inner end 323 may be located on the facing side surface 203, as in the example of Fig. 2A, but may alternatively be located on the upper surface 202.

The intermediate portion 33 of the adhesive 30 has an upper surface 34 opposite to the wiring board 1. Typically, the upper surface 34 is a concave surface.

The adhesive 30 has a relay portion 35 located between the intermediate portion 33 and the wiring board 1 in the Z direction. The relay portion 35 is not located between the semiconductor element 10 and the semiconductor element 20 in the X direction and is not located, in the Z direction, between the semiconductor element 10 and the wiring board 1 and between the semiconductor element 20 and the wiring board 1. The intermediate portion 33 and the lower portion 31 are continuous with each other via the relay portion 35. The intermediate portion 33 and the lower portion 32 are continuous with each other via the relay portion 35.

The adhesive 30 has a bonding surface 303 that bonds to the wiring board 1. The bonding surface 303 has the lower portions 31 and 32, the relay portion 35, and the end portions 36 and 37 of the adhesive 30.

As illustrated in Fig. 2B, the semiconductor element 10 has a non-facing side surface 104 that does not face the semiconductor element 20. The non-facing side surface 104 may be, among the four side surfaces of the semiconductor element 10, any one of three side surfaces other than the facing side surface 103, but is typically a surface opposite to the facing side surface 103.

As illustrated in Fig. 2B, the semiconductor element 20 has a non-facing side surface 204 that does not face the semiconductor element 10. The non-facing side surface 204 may be, among the four side surfaces of the semiconductor element 20, any one of three side surfaces other than the facing side surface 203, but is typically a surface opposite to the facing side surface 203.

In other words, typically, the facing side surfaces 103 and 203 are located between the non-facing side surfaces 104 and 204 in the X direction.

An end of the bonding surface 301 in the vicinity of the non-facing side surface 104 is an outer end 312. The outer end 312 may be located on the non-facing side surface 104 or the lower surface 101, as in the example of Fig. 2B, but may alternatively be located on the upper surface 102. When the outer end 312 is located on the non-facing side surface 104, the bonding surface 301 has a region of the adhesive 30 that bonds to the non-facing side surface 104 of the semiconductor element 10. In some embodiments, the adhesive 30 does not bond to at least part of the upper surface 102.

An end of the bonding surface 302 in the vicinity of the non-facing side surface 204 is an outer end 322. The outer end 322 may be located on the non-facing side surface 204 or the lower surface 201, as in the example of Fig. 2B, but may alternatively be located on the upper surface 202. When the outer end 322 is located on the non-facing side surface 204, the bonding surface 302 has a region of the adhesive 30 that bonds to the non-facing side surface 204 of the semiconductor element 20. In some embodiments, the adhesive 30 does not bond to at least part of the upper surface 202. The outer end 312 is part of the end portion 36 and is exposed to a space. The outer end 322 is part of the end portion 37 and is exposed to a void space.

An edge of the bonding surface 303 in the vicinity of the non-facing side surface 104 is an outer edge 311. An edge of the bonding surface 303 in the vicinity of the non-facing side surface 204 is an outer edge 321. The outer edge 311 is part of the end portion 36 and is exposed to a void space. The outer edge 321 is part of the end portion 37 and is exposed to a void space.

A portion of a surface of the adhesive 30 exposed to a void space that connects the outer edge 311 and the outer end 312 is an end face of the end portion 36. A portion of a surface of the adhesive 30 exposed to a void space that connects the outer edge 321 and the outer end 322 is an end face of the end portion 37. The surface of the adhesive 30 exposed to a void space may include the upper surface 34 of the intermediate portion 33; however, in some embodiments, the upper surface 34 need not be exposed to a void space.

Figs. 2A and 2B illustrate part of the contour 100 of a projection of the semiconductor element 10 onto a plane including the mounting surface 2 in the Z direction (part of the contour 100 or 200 in a certain cross section). The inner ends 313 and 323 illustrated in Fig. 2A are also in a certain cross section, and are part of the inner ends 313 and 323. The outer ends 312 and 322 illustrated in Fig. 2B are also part of the outer ends 312 and 322 in a certain cross section. The outer edges 311 and 321 illustrated in Fig. 2B are also part of the outer edges 311 and 321 in a certain cross section.

Fig. 2A illustrates the width Dc of the intermediate portion 33 in the X direction defined by the semiconductor element 10 and the semiconductor element 20. The width Dc of the intermediate portion 33 may correspond to the spacing between the semiconductor element 10 and the semiconductor element 20 in the X direction. More specifically, the width Dc of the intermediate portion 33 may correspond to the distance between the facing side surface 103 of the semiconductor element 10 that faces the semiconductor element 20 and the facing side surface 203 of the semiconductor element 20 that faces the semiconductor element 10.

Figs. 2A and 2B illustrate the thickness Ta of the lower portion 31 in the Z direction and the thickness Tb of the lower portion 32 in the Z direction.

Figs. 2A and 2B illustrate the thickness Tc of the semiconductor element 10 and the thickness Td of the semiconductor element 20 in the Z direction. The thicknesses Tc and Td may be, for example, 100 µm or more, 300 µm or more, 500 µm or more, 5 mm or less, 3 mm or less, 2 mm or less, or 1 mm or less.

Figs. 2A and 2B illustrate the thickness Te of the wiring board 1 in the Z direction. The thickness Te is, for example, 100 µm or more, 300 µm or more, 500 µm or more, 5 mm or less, 3 mm or less, 2 mm or less, or 1 mm or less.

In Fig. 2A, the distance in the Z direction from the bonding surface 303 to the inner end 313 is shown as the height Hc. In Fig. 2A, the distance in the Z direction from the bonding surface 303 to the inner end 323 is shown as the height Hd. The height Hc may be defined as the distance in the Z direction from the bonding surface to the point where the intermediate portion 33 of the adhesive 30 meets the edge of the semiconductor element 10 (or semiconductor element 20).

In Fig. 2A, the distance in the Z direction from the mounting surface 2 to the upper surface 102 is shown as the height He. In Fig. 2A, the distance in the Z direction from the mounting surface 2 to the upper surface 202 is shown as the height Hf.

In Fig. 2B, the distance in the Z direction from the bonding surface 303 to the outer end 312 is shown as the height Ha. In Fig. 2B, the distance in the Z direction from the bonding surface 303 to the outer end 322 is shown as the height Hb.

In Fig. 2B, the distance Da from a portion of the contour 100 that corresponds to the non-facing side surface 104 to the outer edge 311 is illustrated. In Fig. 2B, the distance Db from a portion of the contour 200 that corresponds to the non-facing side surface 204 to the outer edge 321 is illustrated.

In Fig. 2B, the range Roa extending outward up to the distance Oa from a portion of the contour 100 that corresponds to the non-facing side surface 104 is illustrated. In Fig. 2B, the range Ria extending inward up to the distance la from a portion of the contour 100 that corresponds to the non-facing side surface 104 is illustrated. The sum of the range Roa and the range Ria is illustrated as the range Ra. In Fig. 2B, the range Rob extending up to the distance Ob outward from a portion of the contour 200 that corresponds to the non-facing side surface 204 is illustrated. In Fig. 2B, the range Rib extending inward up to the distance Ib from a portion of the contour 200 that corresponds to the non-facing side surface 204 is illustrated. The sum of the range Rob and the range Rib is illustrated as the range Rb.

In Fig. 2B, the linear distance La from the outer end 312 to the outer edge 311 is illustrated. In Fig. 2B, the linear distance Lb from the outer end 322 to the outer edge 321 is illustrated.

In Fig. 2B, the distance Ea from a portion of the contour 100 that corresponds to the non-facing side surface 104 to the end face 4 is illustrated. In Fig. 2B, the distance Eb from a portion of the contour 200 that corresponds to the non-facing side surface 204 to the end face 4 is illustrated.

In Fig. 2B, a position located at the distance Ga outward from a portion of the contour 100 that corresponds to the non-facing side surface 104 is illustrated. In Fig. 2B, a position located at the distance Gb outward from a portion of the contour 200 that corresponds to the non-facing side surface 204 is illustrated. The distances Ga and Gb may be 5 mm or less, 3 mm or less, 2 mm or less, or 1 mm or less. The distance Ga may be equal to or greater than the height He or may be less than the height He. The distance Gb may be equal to or greater than the height Hf or may be less than the height Hf.

This embodiment is characterized in that the width Dc is small. For example, the width Dc is less than the sum of the thickness Ta and the thickness Tb (Dc < (Ta + Tb)). The lower portion 31 and the lower portion 32 are formed as a liquid adhesive penetrates by capillary action. In other words, the thickness Ta and the thickness Tb are such that capillary action occurs. The gap between the semiconductor element 10 and the semiconductor element 20 is set so that the width Dc satisfies Dc < (Ta + Tb). This enables the intermediate portion 33 between the semiconductor element 10 and the semiconductor element 20 to be formed by a liquid adhesive through capillary action between the semiconductor element 10 and the semiconductor element 20. The liquid surface of the adhesive formed at this time forms a concave meniscus, which may cause the upper surface 34 to be concave.

The width Dc may be, for example, 1 mm or less, 500 µm or less, 300 µm or less, 250 µm or less, 200 µm or less, or 150 µm or less. The width Dc may be, for example, 10 µm or more, 20 µm or more, or 50 µm or more. The thicknesses Ta and Tb may be, for example, 500 µm or less, 250 µm or less, 150 µm or less, 100 µm or less, or 75 µm or less. The thicknesses Ta and Tb may be, for example, 10 µm or more, 20 µm or more, or 50 µm or more.

The outer edge 311 may be located within the range Ra. In the example illustrated in Fig. 2B, the outer edge 311 is located within the range Roa, but may alternatively be located within the range Ria. When the outer edge 311 is located within the range Roa, the non-facing side surface 104 overlaps in the Z direction with the bonding surface 303 of the adhesive 30 that is bonded to the wiring board 1. When the outer edge 311 is located within the range Ria, at least part of a portion of the contour 100 that corresponds to the non-facing side surface 104 does not overlap in the Z direction the bonding surface 303 of the adhesive 30 that is bonded to the wiring board 1.

The distance Oa that defines the range Roa may be smaller than the distance Dc (Oa < Dc). The distance la that defines the range Ria may be smaller than the distance Dc (la < Dc). In other words, the distance Da from a portion of the contour 100 that corresponds to the non-facing side surface 104 to the outer edge 311 may be smaller than the width Dc (Da < Dc).

The outer edge 321 may be located within the range Rb. In the example illustrated in Fig. 2B, the outer edge 321 is located within the range Rob, but may alternatively be located within the range Rib.

When the outer edge 321 is located within the range Rob, the non-facing side surface 204 overlaps in the Z direction with the bonding surface 303 of the adhesive 30 that is bonded to the wiring board 1. When the outer edge 321 is located within the range Rib, at least part of a portion of the contour 200 that corresponds to the non-facing side surface 204 does not overlap in the Z direction with the bonding surface 303 of the adhesive 30 to be bonded to the wiring board 1.

The distance Ob that defines the range Rob may be smaller than the distance Dc (Ob < Dc). The distance Ib that defines the range Rib may be smaller than the distance Dc (Ib < Dc). In other words, the distance Db from a portion of the contour 200 that corresponds to the non-facing side surface 204 to the outer edge 321 may be smaller than the width Dc (Db < Dc).

The distances Da and Db may be, for example, less than 1,000 µm, less than 500 µm, less than 300 µm, less than 250 µm, less than 200 µm, less than 150 µm, equal to or greater than 20 µm, or equal to or greater than 50 µm.

The height Ha may be less than the height Hc (Ha < Hc). The height Hb may be less than the height Hd (Hb < Hd).

The height Hc may be equal to or less than the height He (Hc ≤ He). The height Hd may be equal to or less than the height Hf (Hd ≤ Hf).

The length in the Z direction of the bonding surface between the adhesive 30 and the non-facing side surface 104 may be small. The length in the Z direction of the bonding surface between the adhesive 30 and the non-facing side surface 104 can be expressed as the difference between the height Ha and the thickness Ta. The difference between the height Ha and the thickness Ta may be less than the thickness Tc ((Ha - Ta) < Tc). The difference between the height Ha and the thickness Ta may be less than the width Dc ((Ha - Ta) < Dc). The difference between the height Ha and the thickness Ta may be less than the thickness Ta ((Ha - Ta) < Ta).

The length in the Z direction of the bonding surface between the adhesive 30 and the non-facing side surface 204 may be small. The length in the Z direction of the bonding surface between the adhesive 30 and the non-facing side surface 204 can be expressed as the difference between the height Hb and the thickness Tb. The difference between the height Hb and the thickness Tb may be less than the thickness Td ((Hb - Tb) < Td). The difference between the height Hb and the thickness Tb may be less than the width Dc ((Hb - Tb) < Dc). The difference between the height Hb and the thickness Tb may be less than the thickness Tb ((Hb - Tb) < Tb).

The height Ha may be less than the width Dc (Ha < Dc). The height Hb may be less than the width Dc (Hb < Dc).

The linear distance La may be less than √2 times the width Dc (La < √2 × Dc).

The linear distance Lb may be less than √2 times the width Dc (Lb < √2 × Dc). This is based on the fact that, when the lengths of the two adjacent sides of a right isosceles triangle are set to Ha (Hb) = Dc and Da (Db) = Dc, the length of the hypotenuse of the right isosceles triangle is expressed as √2 × Dc. The linear distances La and Lb may be less than the width Dc.

In the example of Fig. 2B, the distances Ea and Eb are greater than the width Dc (Ea > Dc, Eb > Dc). In such a case, the warpage of the wiring board 1 tends to be large, and therefore, the advantageous effect of this embodiment is more significant. In order to decrease the warpage of the wiring board 1, the distances Ea and Eb may be less than the width Dc (Ea < Dc, Eb < Dc).

In the example of Fig. 2B, the thickness Te is less than the thickness Tc and the thickness Td (Te < Tc, Te < Td). In such a case, the wiring board 1 tends to warp, and therefore, the advantageous effect of this embodiment is more significant. In order to decrease the warpage of the wiring board 1, the thickness Te may be greater than the thickness Tc and the thickness Td (Te > Tc, Te > Td).

The wiring board 1 will be described. The wiring board 1 includes a base material and a wiring material. When the wiring board 1 is a printed-wiring board, the base material is a resin base material such as glass epoxy, and the wiring material is a printed wire or a via made of copper or a similar material. The base material of the wiring board 1 is not limited to the resin base material, but may also be a ceramic base material, a silicon base material, a glass base material (glass core), or a metal base material. Insulating layers and wiring layers may be formed on such a base material, and vias may be formed in the base material to constitute the wiring board 1. The wiring board 1 may be either a motherboard or an interposer. When the wiring board 1 is an interposer, the opposite surface 3 of the wiring board 1 may be connected to the motherboard. The wiring board 1 serving as an interposer may be a silicon interposer or a glass interposer. The silicon interposer may have through-silicon vias (TSVs). The glass interposer may have through-glass vias (TGVs).

The semiconductor elements 10 and 20 will be described. The semiconductor element 10 (20) illustrated in Fig. 1B is a package-type semiconductor element. The semiconductor element 10 (20) includes a semiconductor layer 11 (21), a support substrate 12 (22) that supports the semiconductor layer 11 (21), and a sealing resin 13 (23) that encapsulates the semiconductor layer 11 (21). The support substrate 12 (22) is provided with electrodes and wires. The semiconductor layer 11 (21) is electrically connected to the support substrate 12 (22) by wire bonding or flip-chip bonding. The thickness of the sealing resin 13 (23) is about 100 µm to 1 mm on the semiconductor layer 11. In this case, the distance between the upper surface 102 (202) and the semiconductor layer 11 (21) may be about 100 µm to 1 mm. The semiconductor layer 11 and the semiconductor layer 21 may be formed of a group IV semiconductor or a compound semiconductor. The semiconductor layer 11 and the semiconductor layer 21 may be formed of a single-crystalline semiconductor or a polycrystalline semiconductor. Typical semiconductor layers 11 and 21 are single-crystalline silicon layers.

The outer edge of the bonding surface 303 may be located within the preferable range Ra or Rb, for example, with 25% or more, preferably 50% or more, more preferably 75% or more, still more preferably 90% or more of a portion of the contour 100 that corresponds to one non-facing surface positioned within the range Ra or Rb.

In the example of Figs. 1A and 1B, a total of two semiconductor elements 10 and 20 are arranged to face each other via the intermediate portion 33, in one row in the X direction and two columns in the Y direction; however, the present disclosure is not limited thereto. Alternatively, a total of M × N semiconductor elements may be arranged to face each other via an intermediate portion, in M (M ≥ 1) rows in the X direction and N (N > 1) columns in the Y direction. In this case, among the M × N semiconductor elements, one of opposed two semiconductor elements may be regarded as the semiconductor element 10, and the other may be regarded as the semiconductor element 20.

For example, a total of semiconductor elements in two rows and two columns may be arranged to face each other via the intermediate portion 33. In this case, among the four side surfaces of each semiconductor element, two side surfaces may serve as facing surfaces with respect to the other semiconductor element, and the remaining two side surfaces may serve as non-facing surfaces. In this case, 50% or less of the contour of each semiconductor element may serve as non-facing surfaces. Accordingly, the outer edge of the bonding surface 303 may be located within the preferable range Ra or Rb, for example, with 12.5% or more, preferably 25% or more, more preferably, 37.5% or more, and still more specifically, 45% or more of the contour of each semiconductor element positioned within the range Ra or Rb.

For example, a total of nine semiconductor elements may be arranged in three rows and three columns to face each other via the intermediate portion 33. In this case, the semiconductor elements located in the second row and second column have no non-facing surface. The four semiconductor elements located in the first row and second column, the second row and first column, the second row and third column, and the third row and second column may each have three of their four side surfaces serving as facing surfaces, and the remaining one side surface serving as a non-facing surface with respect to the other semiconductor elements. The four semiconductor elements located in the first row and first column, the first row and third column, the third row and first column, and the third row and third column may each have two of their four side surfaces serve as facing surfaces and the remaining two side surfaces serving as non-facing surfaces.

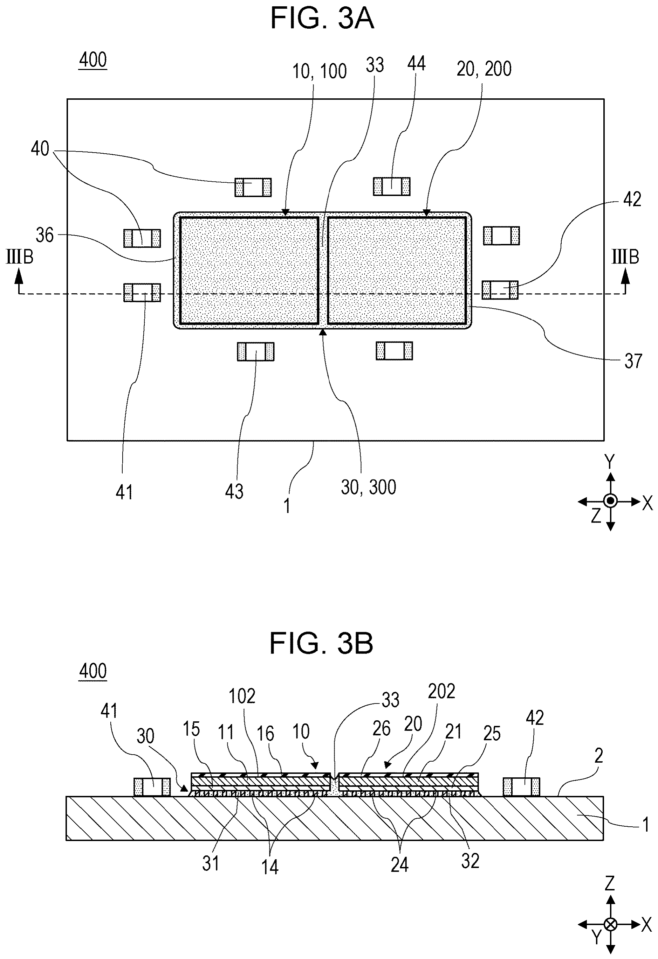

A second embodiment of the present disclosure will be described with reference to Figs. 3A and 3B. Aspects not described with respect to the second embodiment may be the same as those of the other embodiments.

Fig. 3A is a top view of a module 400. Fig. 3B is a cross-sectional view of the module 400 taken along line IIIB-IIIB illustrated in Fig. 3A.

A semiconductor element 10 (20) may include a semiconductor layer 11 (21), a connection structure 15 (25) formed on the front surface of the semiconductor layer 11 (21), and an insulating film 16 (26) formed on the back surface of the semiconductor layer 11 (21). The semiconductor layer 11 (21) is similar to that in the first embodiment. The connection structure 15 (25) includes an insulator such as an interlayer insulating film and a conductor such as a wiring or an electrode. The insulating film 16 (26) functions as a protective film and includes an inorganic insulating layer and/or an organic insulating layer. The inorganic insulating layer may contain a native oxide of the semiconductor layer 11 (21). The upper surface 102 (202) of the semiconductor element 10 (20) may be formed of an insulating film 16 (26). The thickness of the insulating film 16 (26) is about 1 nm to 100 µm on the semiconductor layer 11 (21). In this case, the distance between the upper surface 102 (202) and the semiconductor layer 11 (21) may be 100 µm or less. The insulating film 16 (26) may be omitted, in which case the upper surface 102 (202) of the semiconductor element 10 (20) may be formed of the semiconductor layer 11 (21).

The second embodiment employs a configuration in which Te is greater than each of Tc and Td (Te > Tc, Te > Td). The second embodiment employs a configuration in which Ea is greater than Dc (Ea > Dc) for the three non-facing side surfaces 104, and a configuration in which Eb is greater than Dc (Eb > Dc) for the three non-facing side surfaces 204. Forty percent or more (in this example, 80% or more) of the outer edge 311 is located within the range Roa, and 40% or more (in this example, 80% or more) of the outer edge 321 is located within the range Rob.

A plurality of electronic components 40 are mounted on the mounting surface 2 of the wiring board 1. The electronic components 40 includes electronic components 41, 42, 43, and 44. The electronic components 40 are passive components, and are typically chip components. The electronic components 40 include a resistor, a capacitor, and an inductor. The electronic components 40 are used to ensure proper operation of the semiconductor elements 10 and 20, and examples thereof include a terminating resistor, a bypass capacitor, and a ferrite bead. Some of the electronic components 40 may be disposed closer to the semiconductor element 10 (20) than the position at a distance Ga (Gb) described with reference to Fig. 2B. In this embodiment, the amount of the adhesive 30 located closer to the semiconductor element 10 (20) can be reduced as compared with that located at the position corresponding to the distance Ga (Gb), which reduces a restriction on the arrangement of the electronic components 40 due to the adhesive 30 and enables high-density mounting of the electronic components 40. Furthermore, since the distance between the electronic components 40 and the semiconductor elements 10 and 20 can be decreased, the impedance between the electronic components 40 and the semiconductor elements 10 and 20 can be lowered, thereby contributing to improvement in the operation of the semiconductor elements 10 and 20.

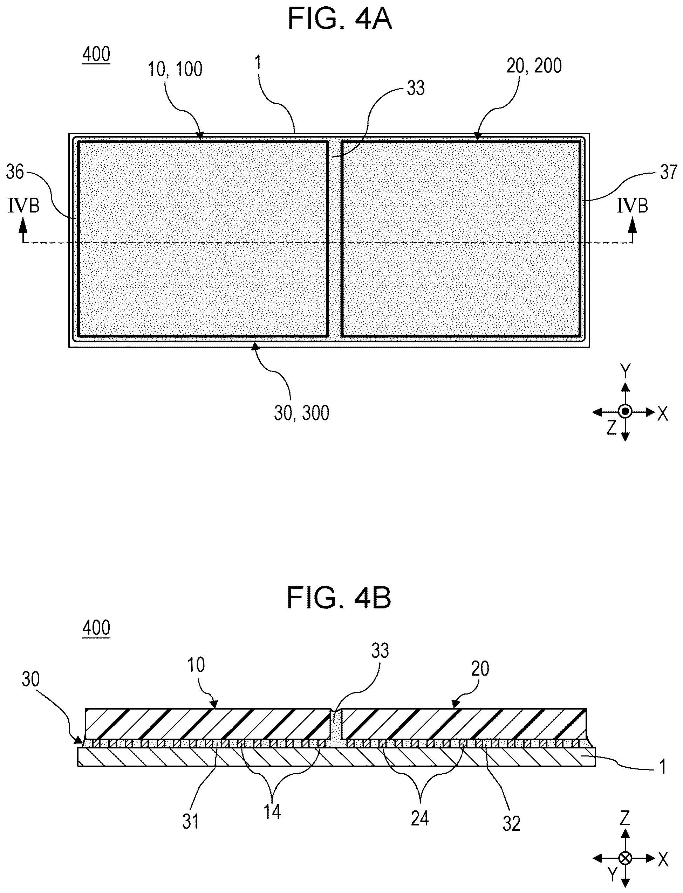

A third embodiment of the present disclosure will be described with reference to Figs. 4A and 4B. Aspects not described with respect to the third embodiment may be the same as those of the other embodiments.

Fig. 4A is a top view of a module 400. Fig. 4B is a cross-sectional view of the module 400 taken along line IVB-IVB illustrated in Fig. 4A.

The third embodiment employs a configuration in which Te is less than each of Tc and Td (Te < Tc, Te < Td). The third embodiment employs a configuration in which Ea is less than Dc (Ea < Dc) for the three non-facing side surfaces 104, and a configuration in which Eb is less than Dc (Eb < Dc) for the three non-facing side surfaces 204. Forty percent or more (in this example, 80% or more) of the outer edge 311 is located within the range Roa, and 40% or more (in this example, 80% or more) of the outer edge 321 is located within the range Rob.

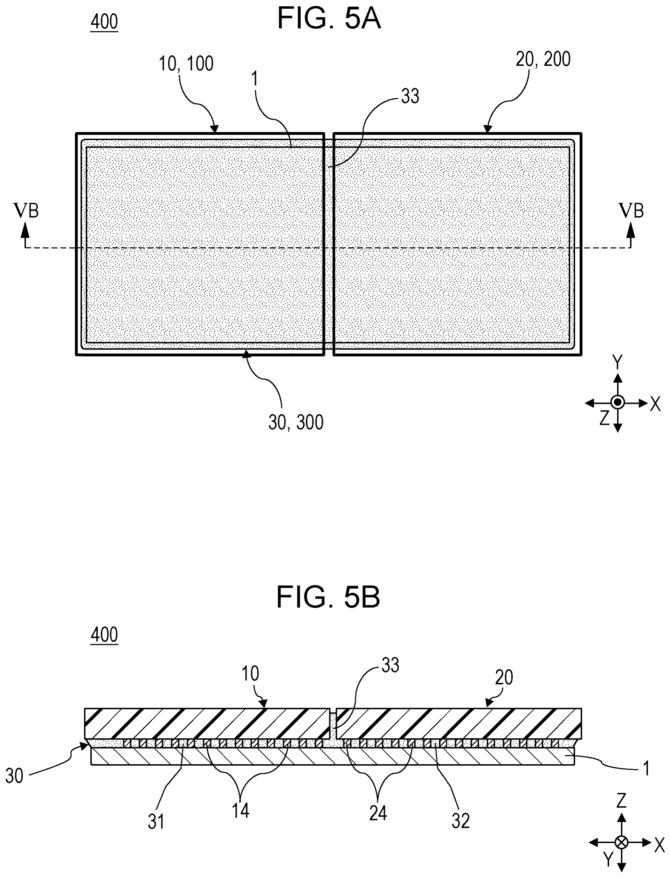

A fourth embodiment of the present disclosure will be described with reference to Figs. 5A and 5B. Aspects not described with respect to the fourth embodiment may be the same as those of the other embodiments.

Fig. 5A is a top view of a module 400. Fig. 5B is a cross-sectional view of the module 400 taken along line VB-VB illustrated in Fig. 5A.

The fourth embodiment employs a configuration in which Te is less than each of Tc and Td (Te < Tc, Te < Td). The fourth embodiment employs a configuration in which Ea is less than Dc (Ea < Dc) for the three non-facing side surfaces 104, and a configuration in which Eb is less than Dc (Eb < Dc) for the three non-facing side surfaces 204. Forty percent or more (in this example, 80% or more) of the outer edge 311 is located within the range Ria, and 40% or more (in this example, 80% or more) of the outer edge 321 is located within the range Rib.

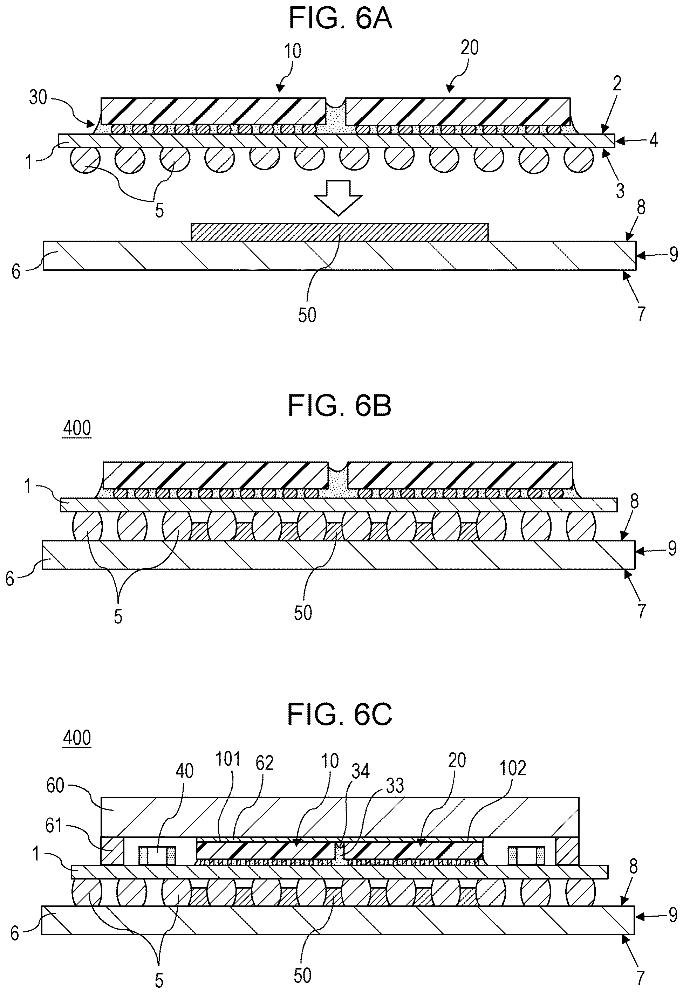

A fifth embodiment of the present disclosure will be described with reference to Figs. 6A and 6B. Aspects not described with respect to the fifth embodiment may be the same as those of the other embodiments.

Figs. 6A and 6B are cross-sectional views of a module 400 according to the fifth embodiment, illustrating a manufacturing process thereof.

As illustrated in Fig. 6A, a plurality of connecting members 5 are provided on the opposite surface 3 of the wiring board 1. A circuit board 6 is disposed on a side of the wiring board 1 opposite to the mounting surface 2. An electronic component 50 is mounted on the mounting surface 8 of the circuit board 6. The electronic component 50 may be a semiconductor element or a passive element. For example, the semiconductor elements 10 and 20 may be memories, and the electronic component 50 may be a processor.

As illustrated in Fig. 6B, the wiring board 1 and the circuit board 6 are electrically connected by the plurality of connecting members 5. According to this embodiment, since warpage of the wiring board 1 is suppressed, electrical connection between the circuit board 6 and the wiring board 1 through the plurality of connecting members 5 can be ensured with high reliability. Specifically, open failures or short-circuit failures of the connecting member 5, which may be caused by warpage of the wiring board 1, are suppressed.

The electronic component 50 disposed between the wiring board 1 and the circuit board 6 may be mounted on the opposite surface 3 of the wiring board 1 instead of the mounting surface 8 of the circuit board 6. Figs. 6A and 6B illustrate a ball grid array (BGA) as an example of the connecting members 5; however, a pin grid array (PGA), a land grid array (LGA), or a combination thereof may alternatively be employed. When the circuit board 6 is a motherboard having a PGA socket, an LGA-type central processing unit (CPU) including the wiring board 1 having an LGA on the opposite surface 3 opposite to the semiconductor elements 10 and 20 serving as a processor can be mounted on the circuit board 6. In addition, a configuration disclosed in Japanese Patent Laid-Open No. 2024-127762 or No. 2023-80425 may also be employed for connection between the wiring board 1 and the circuit board 6.

A sixth embodiment of the present disclosure will be described with reference to Fig. 6C. Aspects not described with respect to the sixth embodiment may be the same as those of the other embodiments.

Fig. 6C is a cross-sectional view of a module 400 according to the sixth embodiment.

The module 400 includes a plate-like member 60 disposed on a side of the wiring board 1 opposite to the semiconductor element 10 and the semiconductor element 20. The distance between the plate-like member 60 and the semiconductor element 10 may be less than the thickness Tc, and more preferably, less than the thickness Ta. The distance between the plate-like member 60 and the semiconductor element 20 may be less than the thickness Td, and more preferably less than the thickness Tb. The plate-like member 60 is fixed to the wiring board 1 by a fixing member 61. The spacing between the plate-like member 60 and the semiconductor elements 10 and 20 may be a gap; however, as illustrated in Fig. 6C, an intermediate member 62 may be provided. The plate-like member 60 has at least one of thermal, electrical, optical, and mechanical functions. Examples of the plate-like member 60 having a thermal function include a heat spreader. In this case, the intermediate member 62 may be a thermally conductive paste or a thermally conductive sheet. Examples of the plate-like member 60 having an electrical function include an electromagnetic shield. Examples of the plate-like member 60 having an optical function include an optical filter and an optical cover. The intermediate member 62 used for the plate-like member 60 having an optical function may be a light-transmissive bonding material. The intermediate member 62 may be in contact with the upper surface 34 of the intermediate portion 33. In any of the plate-like members 60, according to this embodiment, the warpage of the wiring board 1 is suppressed, thereby enabling appropriate positional control of the semiconductor element 10 and the semiconductor element 20 with respect to the plate-like member 60 and allowing the function of the plate-like member 60 to be fully exhibited. For example, when the plate-like member 60 is a heat spreader, warpage of the wiring board 1 may cause a gap to occur between the semiconductor elements 10 and 20 and the plate-like member 60, reducing thermal conduction therebetween. By suppressing warpage of the wiring board 1, the upper surface 102 of the semiconductor element 10 and the upper surface 202 of the semiconductor element 20 can be substantially coplanar with each other, thereby reducing the gap between the semiconductor elements 10 and 20 and the plate-like member 60 and improving thermal conduction therebetween. When the plate-like member 60 has an optical function, misalignment of the optical paths between the plate-like member 60 and the semiconductor elements 10 and 20 can be reduced.

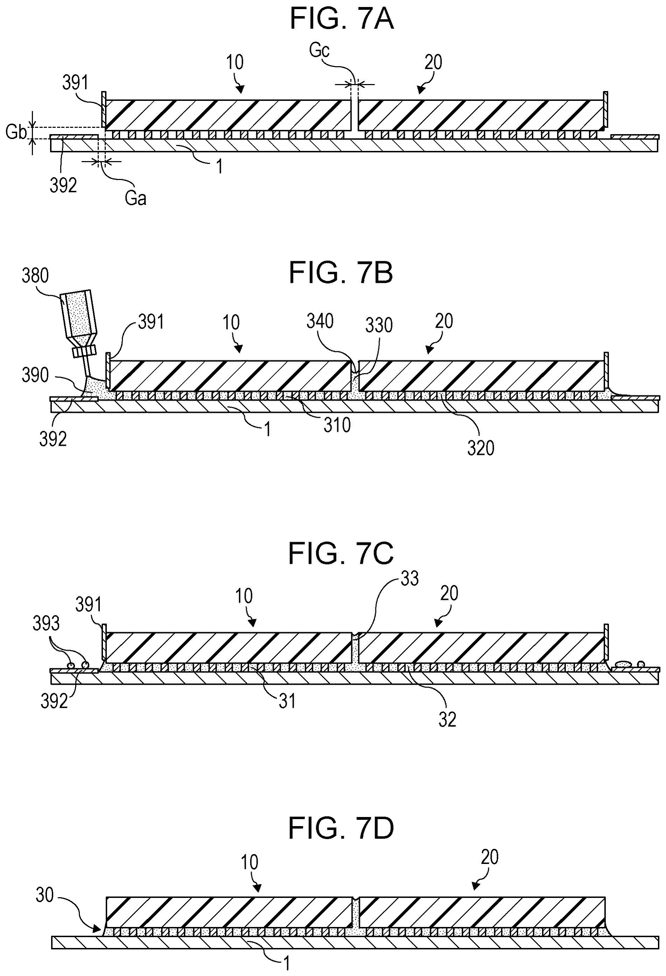

A seventh embodiment of the present disclosure will be described with reference to Figs. 7A to 7D. Aspects not described with respect to the seventh embodiment may be the same as those of the other embodiments.

Figs. 7A to 7D illustrate a method for manufacturing a module 400.

As illustrated in Fig. 7A, the semiconductor elements 10 and 20 are mounted on the wiring board 1 with a spacing of Gc. Masking tapes 391 and 392 for preventing adhesion of the adhesive 30 are attached to the side surfaces of the semiconductor elements 10 and 20 and to the surface of the wiring board 1. The masking tapes 391 and 392 have high oil repellency. The masking tapes 391 and 392 may be made of a fluoroplastic film such as polytetrafluoroethylene (PTFE) or perfluoroalkoxy alkane (PFA). The distance Ga between the semiconductor elements 10 and 20 and the masking tape 392 attached to the wiring board 1 is smaller than the spacing Gc between the semiconductor elements 10 and 20. The distance Gb between the end of the masking tape 391 and the surface of the wiring board 1 is smaller than the spacing Gc between the semiconductor elements 10 and 20.

Fig. 7B is a diagram illustrating a step of injecting an adhesive 390 to the lower surfaces of the semiconductor elements 10 and 20. The adhesive 390 is a thermosetting resin called an underfill. When the adhesive 390 contained in a syringe 380 is applied between the semiconductor elements 10 and 20 and the wiring board 1, specifically to the periphery of the ends of the semiconductor elements 10 and 20, the adhesive 390 flows under the semiconductor elements 10 and 20 by capillary action, thereby forming adhesive portions 310 and 320. The adhesive 390 also flows to the spacing between the semiconductor elements 10 and 20 by capillary action, thereby forming an adhesive portion 330. When the adhesive 390 flows under the lower surfaces of the semiconductor elements 10 and 20 to cover the entire lower surfaces, the adhesive 390 seeps out to sides different from the side where the adhesive 390 is applied, allowing confirmation that the adhesive 390 has flowed under the entire lower surfaces. At this time, the adhesive 390 adhering to the masking tape 391 is repelled and flows off due to the oil repellency of the masking tape 391. For this reason, the contact length of the adhesive 390 that is in contact with the side surfaces of the semiconductor elements 10 and 20 is equal to or less than the region exposed from the masking tape 391, that is, the distance Gb between the end of the masking tape 391 and the surface of the wiring board 1.

Fig. 7C is a diagram illustrating a state after the adhesive 390 is cured by heating. The adhesive 390 that has flowed out of the region where the semiconductor elements 10 and 20 are mounted and has spread on the masking tape 392 forms droplets due to the oil repellency of the masking tape 392, thereby forming residues 393 and being cured in that state. For this reason, the contact length of the adhesive 390 adhering to the wiring board 1 is equal o or less than the distance Ga between the semiconductor elements 10 and 20 and the masking tape 392.

Fig. 7D is a diagram illustrating a state in which the masking tapes 391 and 392 have been removed after curing of the adhesive 390. The granular resin formed of the cured droplet residues 393 can be removed simultaneously with removal of the masking tapes 391 and 392. The length of the adhesive 390 that is in contact with the wiring board 1 out of the electronic component mount region is set equal to or less than the distance Ga between the semiconductor elements 10 and 20 and the masking tape 392, that is, less than the spacing Gc between the semiconductor elements 10 and 20.

A method for controlling the shapes of the end portions 36 and 37 is not limited to the use of the masking tapes 391 and 392 as described above. For example, excess adhesives may be wiped off. Portions having excess adhesives may be separated by cutting the wiring board 1 or by another method.

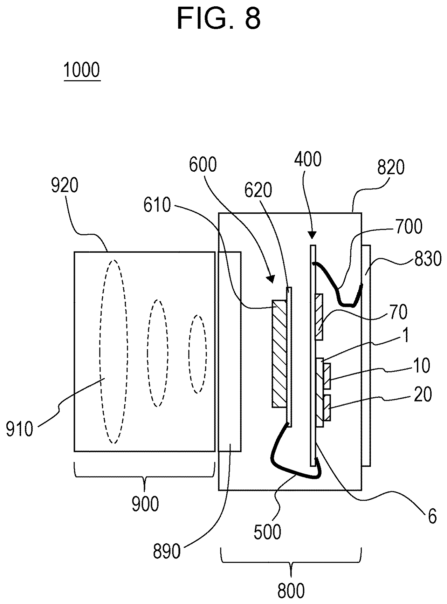

An eighth embodiment of the present disclosure will be described with reference to Fig. 8. Aspects not described with respect to the eighth embodiment may be the same as those of the other embodiments.

A module 400 of this embodiment can be used for various devices or systems in the form of various electronic modules. Fig. 8 illustrates a camera system 1000 including an electronic device 800 (camera body) and an optical device 900 (interchangeable lens). The electronic device 800 includes a module 600 (image capturing module), a module 400 (processing module), and a module 830 (display module). The module 600 is electrically connected to the module 400. The module 830 is electrically connected to the module 400. For example, the electronic device 800 includes a flexible wiring member 500 that connects the module 400 and the module 600. For example, the electronic device 800 includes a flexible wiring member 700 that connects the module 400 and the module 830.

The module 600 includes an image sensor 610 and a wiring board 620 on which the image sensor 610 is mounted. The module 400 includes a circuit board 6, a wiring board 1, and semiconductor elements 10 and 20. The module 830 includes a display element such as a liquid crystal display (LCD) or an organic light emitting diode (OLED).

The circuit board 6 has a control element 70 mounted thereon. A video signal obtained by the image sensor 610 is transmitted to the flexible wiring member 500 and is processed by the module 400. The display element of the module 830 displays an image corresponding to the video signal. The control element 70 controls these operations.

The electronic device 800 includes a mount 890. The mount 890 has an optical device 900 mounted thereon. The optical device 900 includes a lens optical system 910 and a lens barrel 920 that houses the lens optical system 910.

Here, a camera system in which the electronic device is a video apparatus has been described; however, the module of this embodiment can be applied to various types of apparatuses. For example, the electronic device including the module may be an information apparatus such as a smartphone or a personal computer, or a communication apparatus such as a modem or a router. Alternatively, the module may be used in an office or printing apparatus such as a printer, a copier, or a scanner; a medical apparatus such as an X-ray imaging apparatus or an endoscope; an industrial apparatus such as a robot or a semiconductor manufacturing apparatus; or a transportation apparatus such as a vehicle, an airplane, or a ship.

The semiconductor elements 10 and 20 in the module 400 of this embodiment may have various functions, and the functions of the semiconductor elements 10 and 20 may be the same or different.

Examples of the semiconductor elements 10 and 20 include a memory (storage element), a processor (computing element), a sensor (detection element), and a display (display element). Other examples of the semiconductor elements 10 and 20 include a communication element, a control element, and a power supply element.

Examples of the memory (storage element) include a dynamic random access memory (DRAM) and a flash memory. Examples of the processor (computing element) include a CPU, a graphics processing unit (GPU), a neural processing unit (NPU), a digital signal processor (DSP), and an image signal processor (ISP). Examples of the sensor (detection element) include a complementary metal-oxide semiconductor (CMOS) image sensor, a single photon avalanche diode (SPAD) sensor, and a microelectromechanical systems (MEMS) sensor. Examples of the display element include a liquid crystal display and an organic electroluminescent (EL) display.

A module in which a plurality of semiconductor elements are mounted on a single printed circuit board can be incorporated in various types of electronic devices. For example, there is a semiconductor mounting structure called Package On Package (PoP), in which semiconductor packages such as a memory device and an application-specific integrated circuit (ASIC) are vertically stacked. In PoP, an ASIC is often provided in the lower semiconductor package, and a memory device is often provided in the upper semiconductor package. In some types of PoP, a plurality of semiconductor packages to be mounted on the upper stage are mounted on a single printed circuit board to form a module and are thereafter stacked on the lower semiconductor package. Accordingly, by forming multiple modules, a plurality of semiconductor packages can be mounted at the upper stage, enhancing the performance of the PoP.

A chiplet is a semiconductor module in which a plurality of semiconductor chips are mounted on a single printed circuit board. A chiplet is a semiconductor module formed by individually manufacturing semiconductor chips having different process nodes, such as a CPU or a memory device, and mounting the semiconductor chips on a single printed circuit board. By individually manufacturing the plurality of semiconductor chips, non-defective items can be selected and mounted on the printed circuit board, thereby improving the yield of the semiconductor package. Similarly, in some types of optical sensor modules, a plurality of semiconductor elements are mounted on a single printed circuit board to function as a single sensor module. By manufacturing small semiconductor elements, selecting non-defective semiconductor elements, and forming a module using the selected semiconductor elements, a sensor module having a large light-receiving area can be manufactured without using a large optical sensor having a low yield.

Next, a structure will be described in which semiconductor elements and the printed circuit board are connected when semiconductor elements, such as semiconductor packages, semiconductor chips, or semiconductor devices are mounted on the printed circuit board. A semiconductor package to be used on the upper stage of PoP is a ball grid array (BGA) type semiconductor package having a small mounting area and is connected to the printed circuit board via solder balls provided under the lower surface of the BGA. In semiconductor chips used in a chiplet, a plurality of semiconductor chips are mounted closely adjacent to each other, so that wire bonding cannot be used for connection, and are therefore flip-chip mounted on the printed circuit board via bumps or Cu pillars.

In an optical sensor, similarly to a chiplet, sensor chips are flip-chip mounted to be mounted closely adjacent to each other. Such semiconductor module mount structures often employ a structure in which a resin referred to as an underfill is injected and cured between the semiconductor elements and the printed circuit board to reinforce the connections, thereby ensuring connection reliability. The reinforcing structure, such as an underfill, in which only the spacing between the semiconductor elements and the printed circuit board is sealed with a resin has the advantage that, as compared with a method of sealing the entire semiconductor elements with a molding resin, a heat-dissipating member such as a heat sink can be directly attached to the semiconductor elements, thereby facilitating thermal management. Furthermore, in a sensor module, the light-receiving surface is not sealed with a resin, thereby ensuring optical characteristics.

In the reinforcing step using an underfill, a liquid resin is applied to the vicinity of the semiconductor elements on the printed circuit board. The applied resin flows between the semiconductor elements and the printed circuit board by capillary action and flows onto the entire lower surfaces of the semiconductor elements, and an excess resin flows out of the region where the semiconductor elements are mounted and spreads over the printed circuit board and the side surfaces of the semiconductor elements. After the resin flows over the entire lower surface of the semiconductor elements, the entire module is heated with an oven or another heater to cure the resin, thereby completing the reinforcing step. However, the excess resin, that is, the resin on the printed circuit board out of the semiconductor element mounting region is also cured. The excess resin cured out of the semiconductor element mounting region is expanded or shrunk due to a change in the ambient temperature, thereby affecting the thermal deformation of the entire module.

For example, when the module mounted on the upper stage of PoP is greatly warped, a bonding failure is more likely to occur at an intermediate solder joint portion during the process of stacking the module on the lower semiconductor package. When a chiplet-type semiconductor module is greatly warped, a bonding failure is more likely to occur at a solder joint portion during the process of mounting the chiplet on the motherboard.

In an optical sensor module, a deviation may occur in the parallelism between the surfaces of semiconductor sensors arranged in multiple rows, resulting in degradation of the characteristics of the optical sensor. According to this embodiment, a mount failure due to thermal deformation can be suppressed during the process of mounting the module on the printed circuit board. Furthermore, degradation of the characteristics of the optical sensor module due to thermal deformation can also be suppressed.

In response to the above issue, this embodiment provides a structure configured to suppress thermal deformation of a module in which a plurality of semiconductor elements are mounted on a printed circuit board, and a spacing between the semiconductor element and the printed circuit board is sealed with a resin.

According to this embodiment, the thermal deformation of the module can be reduced by making the length of the resin that is in contact with the printed circuit board outside the semiconductor element mounting region smaller than the spacing between the semiconductor elements.

The thermal deformation of the module can be further reduced by making the length of the resin that is in contact with the side surfaces of the semiconductor elements smaller than the spacing between the semiconductor elements. The effect of suppressing the thermal deformation can be further enhanced when the spacing between the semiconductor elements is 200 µm or less.

This effect allows a mounting failure due to thermal deformation to be suppressed during the process of mounting the module on the printed circuit board. This effect also suppresses degradation of the characteristics of the optical sensor module due to thermal deformation.

The embodiments described above may be appropriately modified without departing from the spirit of the present disclosure. For example, two or more embodiments may be combined. Further, certain elements of at least one embodiment may be deleted or replaced. New elements may be added to at least one embodiment.

It should be noted that the disclosure of the present specification includes not only the matters explicitly described herein but also all matters that can be understood from the present specification and the drawings attached hereto. Furthermore, the disclosure of the present specification includes complements of the individual concepts described herein. In other words, when this specification describes, for example, "A is B", even if the case where "A is not B" is omitted, this specification is deemed to disclose the case where "A is not B", because it is premised that the case where "A is not B" is inherently taken into account when describing that "A is B".

As to the specific numerical ranges described in this specification, a description of "e to f" (where e and f are numbers) means "equal to or greater than e" and/or "equal to or less than f". When specific numerical ranges, such as "i to j" and "m to n" (where i, j, m, and n are numbers), are described together, the combinations of the lower and upper limits are not limited to the pair of i and j or m and n. For example, the lower limit and the upper limit of the respective ranges may be combined in various ways. In other words, when the ranges "i to j" and "m to n" are described together, the range may be considered as "i to n" or "m to j" insofar as no contraction arises. In addition, "equal to or greater than e" means e itself or a value greater than e (i.e., exceeding e), and a value greater than e may be adopted instead of e. Similarly, "equal to or less than f" means f itself or a value smaller than f (i.e., less than f), and a value smaller than f may be adopted instead of f.

### EXAMPLE

An example of the module 400 according to the third embodiment described with reference to Figs. 4A and 4B will be described. The mounting surface 2 of the wiring board 1 has a long side of 38 mm and a short side of 18 mm. The wiring board 1 has a thickness Te of 1 mm. The semiconductor elements 10 and 20 each have a contour with a long side of 14 mm and a short side of 8 mm, and have thicknesses Tc and Td of 2 mm, respectively. The semiconductor elements 10 and 20 are arranged with a spacing of 100 µm such that the short sides face each other. The distances Ea and Eb are each 5 mm. The adhesive 30 has thicknesses Ta and Tb of 80 µm, a width Dc of 100 µm, distances Da and Db of 50 µm, heights Ha and Hb of 100 µm, and heights Hc and Hf of about 2 mm. Such a module exhibits reduced warpage of the wiring board 1 and has good mechanical characteristics.

The technique according to the present disclosure provides a module having excellent mechanical characteristics.

Various embodiments have been described in detail above but it will be understood that the present disclosure is not limited to these embodiments but is defined by the scope of the appended claims.

## Claims

1. A module (400) comprising:
a wiring board (1) having a mounting surface (2);
a first semiconductor element (10) and a second semiconductor element (20) that are electrically connected to the wiring board (1), overlap the wiring board (1) in a first direction perpendicular to the mounting surface (2), and are arranged side by side in a second direction along the mounting surface (2); and
an adhesive (30) that bonds, on the mounting surface (2), to the wiring board (1), the first semiconductor element (10), and the second semiconductor element (20),
wherein the adhesive (30) includes a first portion (31) located between the wiring board (1) and the first semiconductor element (10) in the first direction, a second portion (32) located between the wiring board (1) and the second semiconductor element (20) in the first direction, and a third portion (33) located between the first semiconductor element (10) and the second semiconductor element (20) in the second direction,
wherein a width (Dc) of the third portion (33) in the second direction, which is defined by the first semiconductor element (10) and the second semiconductor element (20), is smaller than a sum of a thickness (Ta) of the first portion (31) in the first direction and a thickness (Tb) of the second portion (32) in the first direction, and
wherein a distance (Da) from at least part of a first contour of a projection of the first semiconductor element (10) onto the mounting surface (2) in the first direction to at least part of an outer edge (311) of a board bonding surface, which is a bonding surface of the adhesive (30) bonded to the wiring board (1), is smaller than the width (Dc).

2. The module (400) according to claim 1, wherein a height (Ha) is smaller than a height (Hc), where the height (Ha) is a distance in the first direction from the board bonding surface to at least part of an outer end of a bonding surface of the adhesive (30) bonded to the first semiconductor element (10), and
the height (Hc) is a distance in the first direction from the board bonding surface to at least part of an inner end of the bonding surface of the adhesive (30) bonded to the first semiconductor element (10).

3. The module (400) according to claim 1 or 2,
wherein the first semiconductor element (10) has a first facing surface that faces the mounting surface (2) and a first opposite surface that is opposite to the first facing surface, and
wherein a height (Hc) is equal to or less than a height (He), where the height (Hc) is a distance in the first direction from the board bonding surface to at least part of an inner end of a bonding surface of the adhesive (30) bonded to the first semiconductor element (10), and
the height (He) is a distance in the first direction from the board bonding surface to the first opposite surface.

4. The module (400) according to any one of claims 1 to 3, wherein a linear distance (La) from at least part of an end of a first bonding surface of the adhesive (30) bonded to the first semiconductor element (10) to at least part of the outer edge (311) of the board bonding surface is smaller than √2 times the width (Dc).

5. The module (400) according to any one of claims 1 to 4, wherein at least one of the following conditions is satisfied:
a difference between a height (Ha) and the thickness (Ta) is smaller than the width (Dc);
the height (Ha) is smaller than the width (Dc); and
the difference between the height (Ha) and the thickness (Ta) is smaller than the thickness (Ta), where the height (Ha) is a distance in the first direction from the board bonding surface to at least part of an outer end of a first bonding surface of the adhesive (30) bonded to the first semiconductor element (10).

6. The module (400) according to any one of claims 1 to 5, wherein a distance (Ea) from at least part of the first contour to at least part of an end face of the wiring board (1) is smaller than the width (Dc).

7. The module (400) according to any one of claims 1 to 6, wherein a thickness of the wiring board (1) in the first direction is smaller than thicknesses of the first semiconductor element (10) and the second semiconductor element (20) in the first direction.

8. The module (400) according to any one of claims 1 to 7, wherein a surface of the third portion (33) that is opposite to the mounting surface (2) is a concave surface.

9. The module (400) according to any one of claims 1 to 8, wherein a distance (Db) from at least part of a second contour of a projection of the second semiconductor element (20) onto the mounting surface (2) in the first direction to at least part of an outer edge (321) of the board bonding surface, which is a bonding surface of the adhesive (30) bonded to the wiring board (1), is smaller than the width (Dc).

10. The module (400) according to any one of claims 1 to 9,
wherein a height (Hb) is smaller than a height (Hd), where the height (Hb) is a distance in the first direction from the board bonding surface to at least part of an outer end of a bonding surface of the adhesive (30) bonded to the second semiconductor element (20), and
the height (Hd) is a distance in the first direction from the board bonding surface to at least part of an inner end of the bonding surface of the adhesive (30) bonded to the second semiconductor element (20).

11. The module (400) according to any one of claims 1 to 10,
wherein the second semiconductor element (20) has a second facing surface that faces the mounting surface (2) and a second opposite surface that is opposite to the second facing surface, and
wherein a height (Hd) is equal to or less than a height Hf, where the height (Hd) is a distance in the first direction from the board bonding surface to at least part of an inner end of a bonding surface of the adhesive (30) bonded to the second semiconductor element (20), and
the height Hf is a distance in the first direction from the board bonding surface to the second opposite surface.

12. The module (400) according to any one of claims 1 to 11, wherein a linear distance (Lb) from at least part of an end of a second bonding surface of the adhesive (30) bonded to the second semiconductor element (20) to at least part of an outer edge (321) of the board bonding surface is smaller than √2 times the width (Dc).

13. The module (400) according to any one of claims 1 to 12, wherein at least one of the following conditions is satisfied:
the width (Dc) is equal to or less than 200 µm;
the thickness (Ta) and the thickness (Tb) are equal to or less than 100 µm; and
the distance (Da) is equal to or less than 100 µm.

14. The module (400) according to any one of claims 1 to 13, wherein at least one of the following conditions is satisfied:
the first semiconductor element (10) has a first facing surface that faces the mounting surface (2) and a first opposite surface that is opposite to the first facing surface;
the second semiconductor element (20) has a second facing surface that faces the mounting surface (2) and a second opposite surface that is opposite to the second facing surface;
the adhesive (30) does not bond to at least part of the first opposite surface and at least part of the second opposite surface;
the first opposite surface is formed of a first semiconductor layer included in the first semiconductor element (10), and the second opposite surface is formed of a second semiconductor layer included in the second semiconductor element (20);
the first opposite surface is formed of a first insulating film that covers the first semiconductor layer included in the first semiconductor element (10), a distance between the first opposite surface and the first semiconductor layer being equal to or less than 100 µm; and
the second opposite surface is formed of a second insulating film that covers the second semiconductor layer included in the second semiconductor element (20), a distance between the second opposite surface and the first semiconductor layer being equal to or less than 100 µm.

15. The module (400) according to any one of claims 1 to 14, further comprising:
an electronic component (40, 41, 42, 43, 44) mounted on the mounting surface (2),
wherein a distance from the first semiconductor element (10) to the electronic component (40, 41, 42, 43, 44) is equal to or less than 2 mm.

16. The module (400) according to any one of claims 1 to 15, further comprising:
a circuit board (6) located on a side of the wiring board (1) that is opposite to the mounting surface (2),
wherein at least one of the following conditions is satisfied:
the wiring board (1) and the circuit board (6) are electrically connected to each other; and
an electronic component (40, 41, 42, 43, 44) is provided between the wiring board (1) and the circuit board (6).

17. The module (400) according to any one of claims 1 to 16, further comprising:
a plate-like member (60) disposed on a side of the first semiconductor element (10) and the second semiconductor element (20) that is opposite to the wiring board (1),
wherein a spacing between the plate-like member (60) and the first semiconductor element (10) is smaller than a thickness (Tc) of the first semiconductor element (10), and
wherein a spacing between the plate-like member (60) and the second semiconductor element (20) is smaller than a thickness Td of the second semiconductor element (20).

18. An apparatus comprising:
a first module (400) that is the module (400) according to any one of claims 1 to 17; and
a second module (600, 830) electrically connected to the first module (400),
wherein at least one of the following conditions is satisfied:
the first semiconductor element (10) and the second semiconductor element (20) are any one of a memory, a processor, a sensor, and a display;
the apparatus includes a flexible wiring member (500, 700) that connects the first module (400) and the second module (500, 700); and
the apparatus is any one of a video apparatus, a printing apparatus, a medical apparatus, and an industrial apparatus.
